# EUROPEAN PATENT APPLICATION

(11) **EP 0 539 197 A1**
(43) Date of publication of application: **28.04.1993**
(21) Application number: 92309651.5
(22) Date of filing: 22.10.1992
(51) Int. Cl.: H01L 23/525, H01L 25/525

(54) **Semiconductor device with anti-fuse and production method**

(30) Priority: 23.10.1991 JP 275822/91; 23.10.1991 JP 275823/91; 25.10.1991 JP 278206/91
(71) Applicant: FUJITSU LIMITED, Kawasaki-shi, Kanagawa 211 (JP)
(72) Inventor: Saiki, Takashi, c/o Fujitsu Limited, Kawasaki-shi, Kanagawa 211 (JP); Mochizuki, Akitoshi, c/o Fujitsu Limited, Kawasaki-shi, Kanagawa 211 (JP); Tsuzuki, Norihisa, c/o Fujitsu Limited, Kawasaki-shi, Kanagawa 211 (JP)
(74) Representative: Rackham, Stephen Neil

(57) **Abstract**

A semiconductor device (e.g. FPGA, PROM) with an anti-fuse comprising: a semiconductor substrate (41, 61); an insulating layer (42, 62) formed on the semiconductor substrate; a lower wiring layer (43a, 63) formed above the insulating layer; an amorphous semiconductor layer (45, 65) formed above the lower wiring layer; an interlaminar insulating layer (50, 66) which is formed on the insulating layer and the amorphous semiconductor layer and has contact holes (52a, 52b) reaching the amorphous semiconductor layer; and an upper wiring layer (53, 72a) which is formed on the interlaminar insulating layer and is connected to the amorphous semiconductor layer through the contact hole (52a, 52b). When the lower wiring layer and the upper wiring layer are aluminium, preferably, a lower barrier layer (44, 64) and an upper barrier layer (46, 56a, 71a, 76a) are formed between the amorphous semiconductor layer and the lower and upper wiring layers, respectively.

## Description

The present invention relates to a semiconductor device, such as an IC device and an LSI device, and more particularly, to a semiconductor device provided with anti-fuses.

An anti-fuse is formed in a logic cell of a user-programmable logic device such as a FPGA (Field Programmable Gate Array) or a memory cell of a PROM (Programmable Read Only Memory). The anti-fuse is a fuse which has a very high electrical resistance (i.e., does not pass an electric current therethrough) in an initial state in contrast to a usual blowable fuse, and which becomes conductive by a writing operation.

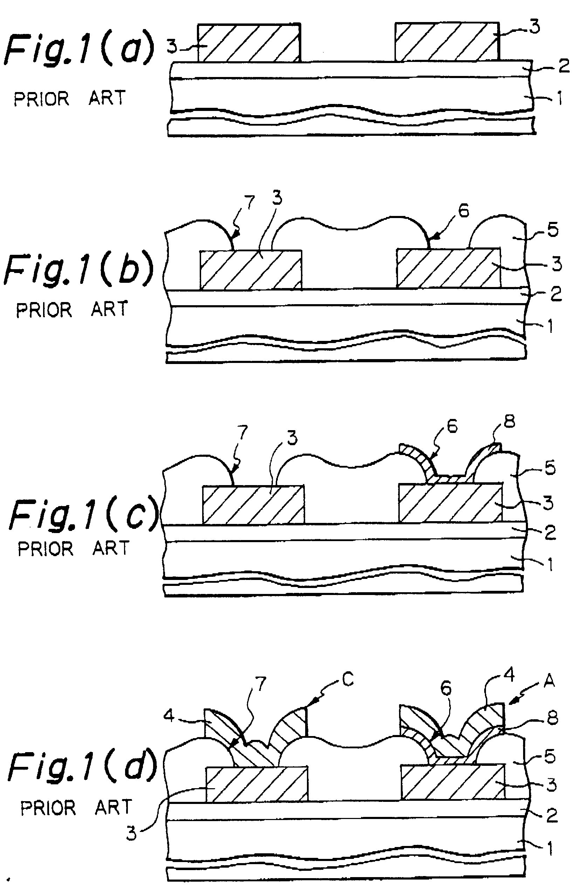

As shown in Fig. 1d, where a lower wiring (metal) layer 3 formed on an insulating layer 2 of a semiconductor substrate 1 is connected with an upper wiring (metal) layer 4 through contact holes (windows) 6 and 7 formed (opened) in an interlaminar insulating layer 5 between the wiring layers 3 and 4, an anti-fuse structure A is set by forming an amorphous silicon layer 8 between the lower wiring layer 3 and the upper wiring layer 4 at the predetermined contact hole 6. In Fig. 1d, at a usual contact structure C the upper wiring layer 4 comes directly into contact with the lower wiring layer 3 in the contact hole 7. FPGA using anti-fuses is disclosed in, e.g., J. Birkner et al: "a very high-speed field programmable gate array using metal-to-metal antifuse programmable element", IEEE 1991, Custom integrated circuits conference, Paper 1. 7, pp. 1-6.

The semiconductor device provided with such an anti-fuse is produced in the following manner.

As shown in Fig. 1a, on a semiconductor substrate 1 of, e.g., silicon, an insulating layer 2 is formed and thereon lower wiring (metal) layers 3 are formed. Next, as shown in Fig. 1b, an interlaminar insulating layer 5 is deposited to cover the whole surface and then is selectively etched to open contact holes (windows) 6 and 7. In the contact holes 6 and 7 portions of the lower wiring layers 3 are exposed.

Next, an amorphous silicon layer (having a thickness of about 100 nm) is deposited on the whole surface by a CVD method, and is patterned by a photolithography method so as to leave an amorphous silicon layer 8 for an anti-fuse in and around the contact hole 6, as shown in Fig. 1c. Then, a metal layer of, e.g., aluminum is deposited on the whole surface and is patterned to form upper wiring layers 4, as shown in Fig. 1d. One of the wiring layers 4 lies on the amorphous silicon layer 8 at the anti-fuse structure A, and the other comes directly in contact with the lower wiring layer 3 at the contact region C.

In such a state of the anti-fuse A, the amorphous silicon layer 8 has an electric resistance of about 100 MΩ, whereby the amorphous silicon layer 8 is held in a nonconducting state (normally open state) and prevents the current from substantially passing between the lower wiring layer 3 and the upper wiring layer 4. To change the amorphous silicon layer 8 of the anti-fuse structure A from the open state to a conductive state so as to substantially pass the current between the wirings 3 and 4 in accordance with a programming, a writing voltage is applied across the wirings 3 and 4 to generate Joule heat, whereby a portion of the amorphous silicon is changed to a polycrystalline silicon to decrease the resistance the silicon layer 8 in 150 to 50Ω.

In normal semiconductor devices aluminum (Al, Al-Si, Al-Cu, Al-Si-Cu or the like) is widely used as a metal of wiring layers. Where the aluminum wiring layer comes in contact with an amorphous silicon layer, aluminum diffuses into the amorphous silicon layer at a substrate heating of a CVD process or an annealing treatment to decrease the resistance of the amorphous silicon layer. To prevent the decrease of the resistance, between the aluminum wiring layer and the amorphous silicon layer a barrier layer (of TiW, W, Mo, TiN, WN, TaN and the like) is formod (cf., e.g., Brian Cook, Steve Keller: "Amorphous Silicon Antifuse Technology for Bipolar PROMS." Bipolar circuits and technology meeting, IEEE, 1989, pp.99-100 and Japanese Unexamined Patent Publication No. 3-179763 (corresponding to EP-0,414,361-A2).

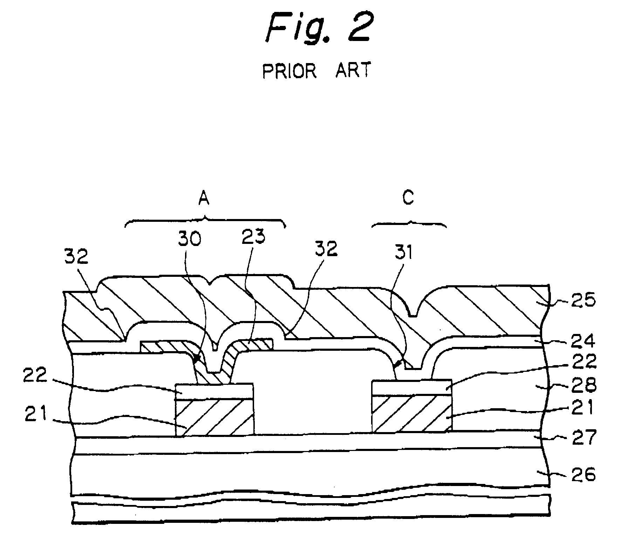

According to a conventional semiconductor device with another anti-fuse structure, as shown in Fig. 2, the anti-fuse structure A comprises an aluminum lower wiring layer 21, a TiN lower barrier layer 22, an amorphous silicon layer 23 for an anti-fuse, a TiN upper barrier layer 24 and an aluminum upper wiring layer 25. In this case, an insulating layer 27 is formed on a silicon semiconductor substrate 26, and the lower wiring layer 21 is formed on the layer 27. After the TiN lower barrier layer 22 is formed on the lower wiring layer 21, an interlaminar insulating layer 28 is deposited on the whole surface and is selectively etched to form contact holes (open windows) 30 and 31. The amorphous silicon layer 23 is selectively formed in and around the contact hole 30. Then, on the whole surface TiN and aluminum are successively deposited, and are patterned to form the upper wiring layer 25 and the Tin upper barrier layer 24 under the wiring layer 25. In the contact hole 31 the upper wiring layer 25 is electrically connected with the lower wiring layer 21 through the TiN barricr layers 22 and 24, whereby a normal contact structure C is formed.

When such conventional anti-fuse structures are formed, a contact hole is formed in the interlaminar insulating layer, and then amorphous silicon is deposited so as to cover the contact hole and is patterned to form the amorphous silicon layer for an anti-fuse. As device dimensions decrease in accordance with device miniaturization demands, contact hole size is also decreased. In such a case, a thickness of the amorphous silicon layer in one contact hole is not uniform (constant), a coverage of the amorphous silicon layer in a bottom corner of the contact hole is not uniform, and there is scattering of the thickness among a plurality of contact holes. Therefore, a writing voltage and a post-fuse resistance (i.e., an electric resistance of the amorphous silicon layer in a conductive state) are not determined at a certain value, and thus characteristics of a semiconductor circuit including the anti-fuse become unstable and scattered.

Furthermore, where the barrier layer is formed between the amorphous silicon layer and the upper wiring layer, in the case of Fig. 2, the barrier layer 24 is required to have a good step-coverage at an edge of the silicon layer 23, indicated by a point 32. Thus, it is necessary to increase the thickness of the barrier layer 24. Depending on the increase of the barrier layer thickness, an unevenness of a surface profile of the upper wiring layer 25 becomes larger and causes an undesirable condition.

According to a first aspect of this invention, a semiconductor device with an anti-fuse comprises:
a semiconductor substrate;
an insulating layer formed on said semiconductor substrate;
a lower wiring layer formed above said insulating layer;
an amorphous semiconductor layer formed above said lower wiring layer;
an interlaminar insulating layer which is formed on said insulating layer and said amorphous semiconductor layer and has contact holes reaching said amorphous semiconductor layer; and,
an upper wiring layer which is formed on said interlaminar insulating layer and is connected to said amorphous semiconductor layer through said contact hole.

When the lower wiring layer is of aluminum, preferably, a lower barrier layer is formed between the amorphous semiconductor layer and the lower wiring layer. When the upper wiring layer is of aluminum, preferably, an upper barrier layer is formed between the amorphous semiconductor layer and the upper wiring layer. In such a case, the upper barrier layer is formed (1) on the amorphous semiconductor layer, (2) in the contact hole only, or (3) under the upper wiring layer.

Preferably, the amorphous semiconductor layer for an anti-fuse is an amorphous silicon layer. Furthermore, the lower barrier layer and upper barrier layers are made of tungsten, molybdenum, tantalum, titanium-tungsten, titanium nitride, tungsten nitride or tantalum nitride (preferably, titanium nitride or tungesten). The lower wiring layer and upper wiring layer are preferably made of aluminum, polycrystalline silicon, metal silicide, polycide or refractory metal.

According to a second apsect of this invention, a method of producing a semiconductor device with an anti-fuse comprises the steps of:
(a) forming an insulating layer (42, 62) on a semiconductor substrate (41, 61);
(b) forming a lower wiring layer (43a, 63) above said insulating layer;
(c) forming an amorphous semiconductor layer (45, 65) for an anti-fuse above said lower wiring layer;
(d) forming an interlaminar insulating layer (50, 66) having a contact hole (52a, 52b) reaching said amorphous semiconductor layer, on said insulating layer and said amorphous semiconductor layer; and,
(e) forming an upper wiring layer (53, 72a) connecting to said amorphous semiconductor layer through said contact hole, on said interlaminar insulating layer.

Preferably, a lower barrier layer is formed on the lower wiring layer between the steps (b) and (c) or between the steps (c) and (d).

Furthermore, it is possible to form an upper barrier layer between the steps (d) and (e). In such a case, the upper wiring layer is formed by patterning a conductive layer and successively patterning the upper barrier layer into the same pattern as that of the upper wiring layer, or the upper barrier layer is formed in the contact hole only and on the amorphous semiconductor layer.

According to the present invention, since the amorphous semiconductor layer for an anti-fuse is formed prior to the formation of the interlaminar insulating layer (namely, the amorphous semiconductor layer is not formed after the formation of the contact hole in the interlaminar insulating layer), it is possible to form the amorphous semiconductor layer having an uniform thickness on the lower wiring layer (or the lower barrier layer) without influence of the contact hole size. Therefore, when the contact hole (window) is formed (opened) in the interlaminar insulating layer deposited on the amorphous semiconductor layer, a portion of the amorphous semiconductor layer in the uniform thickness appears in the contact hole with the result that no trouble caused by the nonuniform thickness and scattering of the amorphous semiconductor layer occurs. Accordingly, the writing voltage and the post-fuse (ON) resistance of the anti-fuse of the amorphous semiconductor layer are determined at certain values and circuit characteristics are stable at certain values.

The present invention will now be described and contrasted with the prior art with reference to the accompanying drawings, in which:-
Figs. 1a to 1d are schematic sectional views of a conventional semiconductor with an anti-fuse in various stages of production thereof;
Fig. 2 is a schematic sectional view of another conventional semiconductor device with an anti-fuse;
Figs. 3 to 7 are schematic sectional views of a semiconductor device according to a first embodiment of the present invention in various stages of production thereof;
Fig. 8 is a schematic plan view of the semiconductor device of Fig. 7;
Figs. 9 to 13 are schematic sectional views of a semiconductor device according to a second embodiment of the present invention in various stages of production thereof;
Fig. 14 is a schematic plan view of the semiconductor device of Fig. 13;
Figs. 15 to 19 are schematic sectional views of a semiconductor device according to a third embodiment of the present invention in various stages of production thereof;
Figs. 20 and 21 are schematic sectional views of a semiconductor device according to a fourth embodiment of the present invention in various stages of production thereof; and
Figs. 22 and 23 are schematic sectional views of a semiconductor device according to a fifth embodiment of the present invention in various stages of production thereof.

### Example 1

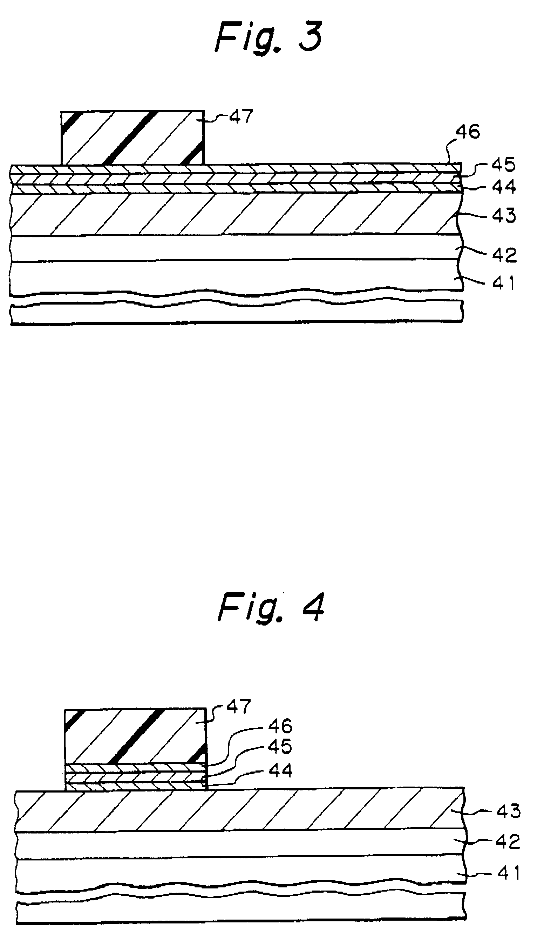

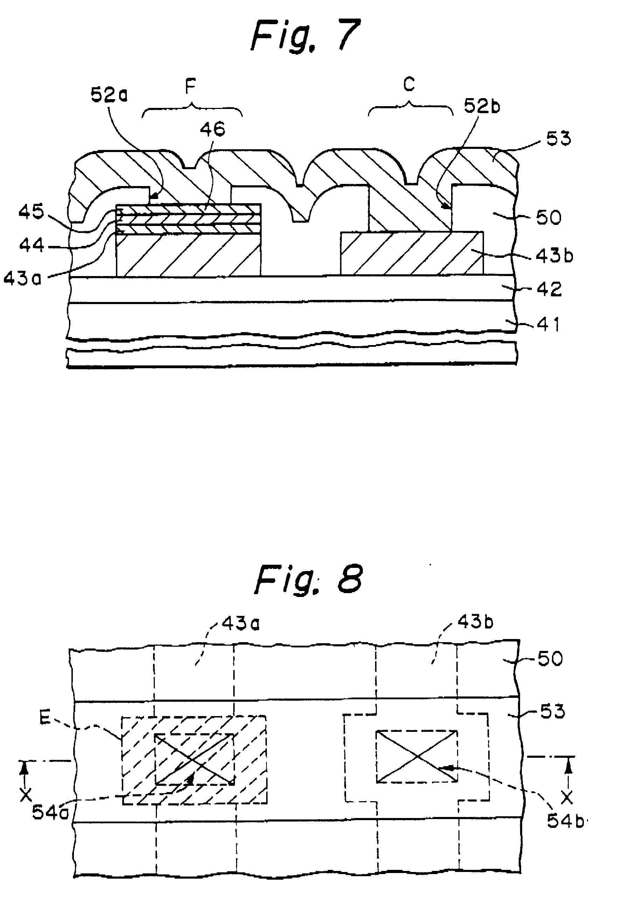

Referring to Figs. 3 to 8, a semiconductor device provided with an anti-fuse according to the first embodiment of the present invention is produced as follows. Figure 7 is a sectional view taken on line X-X of Fig. 8.

As shown in Fig. 3, an insulating layer (e.g., a SiO₂ layer) 42 is formed on a semiconductor substrate 41 such am a silicon wafer by a thermal oxidizing process or a CVD process. On the whole surface of the insulating layer 42, an aluminum layer (having a thickness of about 500 nm) 43 is deposited by a vacuum evaporation process or a sputtering process and successively a titanium nitride (TiN) layer (having a thickness of about 100 nm) 44 for a lower barrier layer is deposited by a sputtering process. The sputtering process uses a nitrogen gas which collides with a titanium target to eject titanium from its surface.

Next, an amorphous silicon layer (having a thickness of from 80 to 110 nm) 45 is deposited on the titanium nitride layer 44 by a CVD process or a sputtering process. The CVD process is carried out by a reducing reaction of silane (SiH₄) or disilane (Si₂H₆) at a growth (substrate) temperature of from 400 to 500°C, and the sputtering process uses an argon gas which collides with a silicon target to eject silicon from its surface. The amorphous silicon layer 45 may be doped with impurities by an ion-implantation process. When the ion-implantation process is carried out, elements in the groups III and V such as phosphorus, arsenic, and boron are suitable as ion species, its dose is in the range of about 1 x 10¹⁴ to 1 x 10¹⁶ atoms/cm², and an implantation energy is such that the impurities do not pass through the amorphous silicon layer 45. If a heat-treatment at 600°C or more is applied, amorphous silicon (α-Si) is inconveniently polycrystallized. Accordingly, an activation annealing after ion-implantation should not be performed.

Then, a titanium nitride layer (having a thickness of about 100 nm) 46 for an upper barrier layer is deposited on the amorphous silicon layer 45 by a CVD process or a sputtering process. Thereafter, a photoresist is applied on the titanium nitride layer 46, exposed and developed so as to leave a resist layer 47 on only an anti-fuse formation region (a hatched region E in Fig. 8) including a contact region.

As shown in Fig. 4, by using the resist layer 47 as a mask, the titanium nitride layer 46, the amorphous silicon layer 45 and the titanium nitride layer 44 are selectively and successively etched by a RIE process or a plasm etching process. As a result, under the resist layer 47 only, the portions of the layers 46, 45 and 44 in the shape of the anti-fuse formation region E remain. Then, the resist layer 47 is removed with a solvent or by an ashing process.

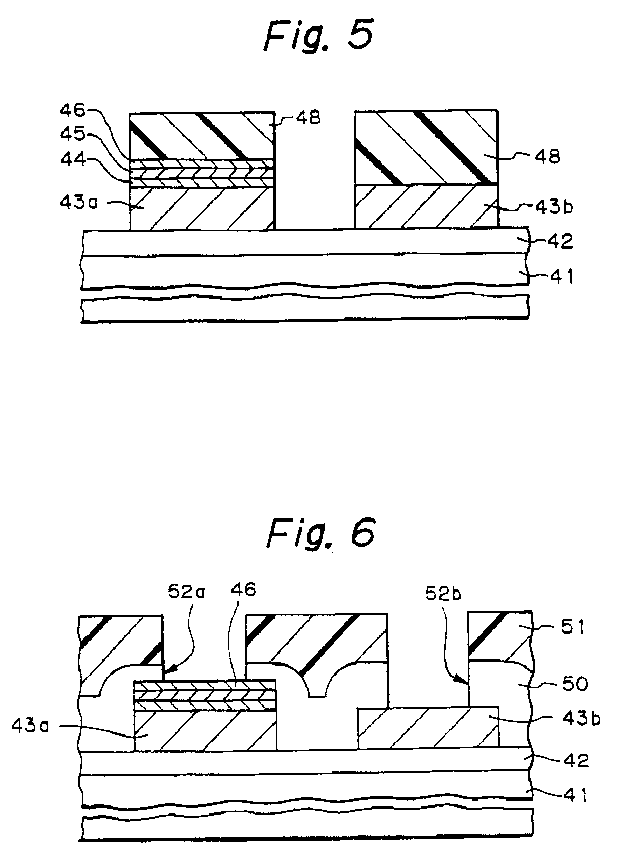

Next, as shown in Fig. 5, another photoresist is applied on the whole surface, exposed in a lower wiring pattern, and developed to form a resist layer 48 having the lower wiring pattern. By using the resist layer 48 as a mask, the aluminum layer 43 is selectively etched by a RIE process or a plasma etching process to form the lower wiring layers 43a and 43b. Then, the resist layer 48 is removed with a solvent or by an ashing process.

As shown in Fig. 6, an interlaminar insulating layer 50 of SiO₂, PSG or the like is deposited on the whole surface by a CVD process. A photoresist is applied on the whole surface, exposed in a contact hole pattern, and developed to form a resist layer 51 having openings corresponding to contact holes 52a and 52b. By using the resist layer 51 as a mask, the interlaminar insulating layer 50 is selectively etched by a RIE process or a plasma etching process to open the contact holes 52a and 52b. The titanium nitride layer 46 is exposed in the contact hole 52a, and the aluminum lower wiring layer 43b is exposed in the contact hole 52b. Then, the resist layer 51 is removed with a solvent or by an ashing process.

Next, as shown in Figs. 7 and 8, an aluminum layer 53 is deposited on the whole surface of the interlaminar insulating layer 50 with the contact holes 52a and 52b by a vacuum vapor deposition process, a sputtering or the like. A resist layer (not shown) having an upper wiring pattern shape is formed on the aluminum layer 53. By using the resist layer as a mask, the aluminum layer 53 is selectively etched by a RIE process or a plasma etching process to form an upper wiring layer 53. Then, the resist layer 51 is removed with a solvent or by an ashing process.

The produced semiconductor device with an anti-fuse includes an anti-fuse structure F in which the aluminum upper wiring layer 53 comes in contact with a contact region 54a of the titanium nitride layer 46 in the contact hole 52a, and a normal contact structure C in which the upper wiring layer 53 comes in contact with a contact region 54b of the aluminum lower wiring layer 43b in the contact hole 52b.

Since the amorphous silicon layer 45 is formed between the lower wiring layer and the interlaminar insulating layer and deposited on a flat surface, the layer 45 has an uniform thickness at a predetermined value without influence of the size of the contact hole 52a. Therefore, the writing voltage and ON resistance of the anti-fuses are determined at the predetermined values and are not scattered, so that the circuit characteristics are stable. In an initial state prior to a programming operation, the amorphous silicon layer 45 has a large resistance of about 100 MΩ, whereby the anti-fuse structure F is in a nonconductive state (open state) between the lower wiring layer 43a and the upper wiring layer 53. Furthermore, since the lower and upper barrier layers 44 and 46 separate the amorphous silicon layer 45 from the lover and upper aluminum layers 43a and 53, respectively, to prevent diffusion of aluminum into the amorphous silicon layer 45, the resistance of the silicon layer 45 is not varied (decreased).

When a pulse voltage of 8 to 11V (e.g., 10V) is applied across the lower wiring layer 43a and the upper wiring layer 53 in the anti-fuse structure F, Joule heat is locally generated in the amorphous silicon layer 45 to change a portion of the amorphous silicon layer 45 to a polycrystalline state with the result that the resistance of the layer 45 is decreased to about 150Ω. The polycrystalline portion of the layer 45 can pass the current between the lower and upper wiring layers 43a and 53, and thus the amorphous silicon layer 45 enters a conductive state. The polycrystalline portion cannot be returned (changed) to amorphous silicon, and thus the post-fuse (ON) resistance of 100Ω is maintained. Therefore, among a plurality of the anti-fuse structures formed in an integrated circuit of a semiconductor device the predetermined ones enters a conductive state so as to form a logic circuit.

### Example 2

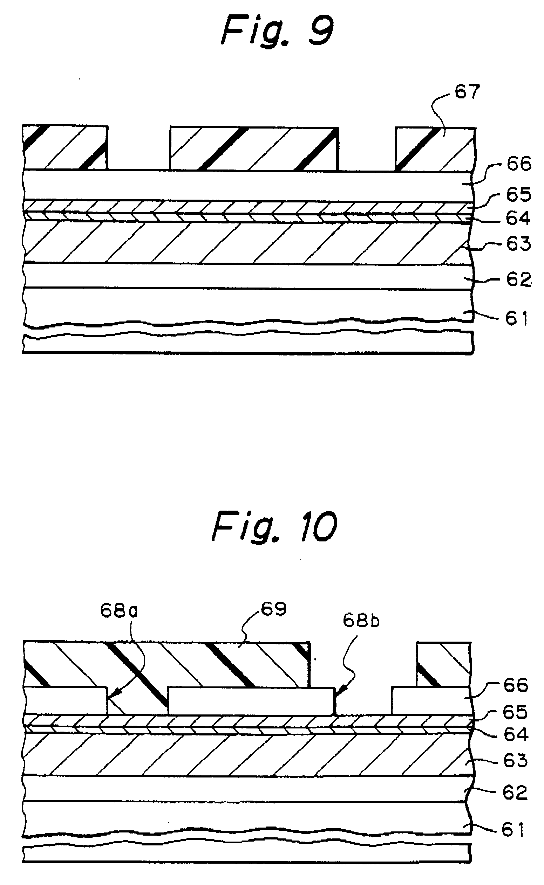

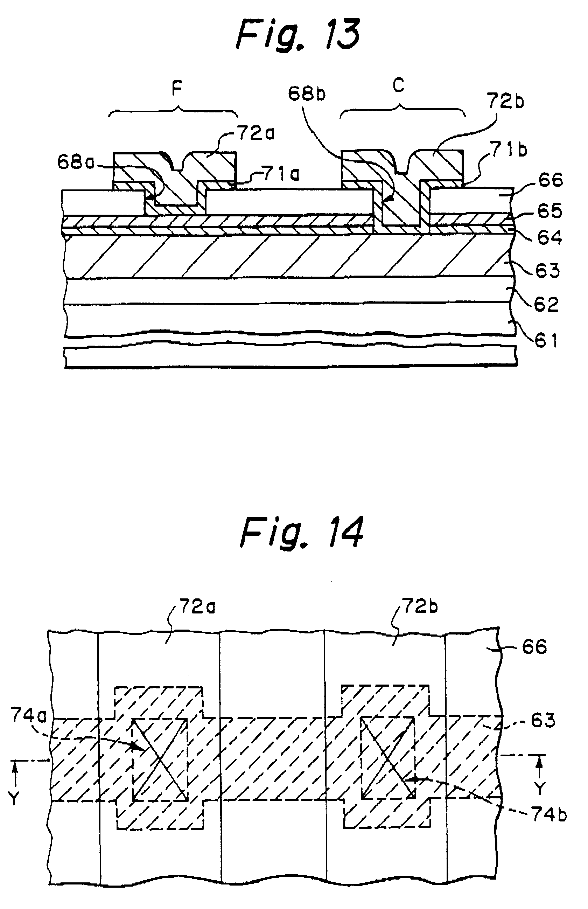

Referring to Figs. 9 to 14, a semiconductor device provided with an anti-fuse according to the second embodiment of the present invention is produced as follows. Figure 13 is a sectional view taken on line Y-Y of Fig. 14.

As shown in Fig. 9, an insulating layer (e.g., a SiO₂ layer) 62 is formed on a semiconductor substrate 61 such as a silicon wafer by a thermal oxidizing process or a CVD process. On the whole surface of the insulating layer 62, an aluminum layer 63 is deposited by a vacuum evaporation process, or a sputtering process and successively a titanium nitride (TiN) layer 64 for a lower barrier layer is deposted by a sputtering process. Next, an amorphous silicon layer 65 is deposited on the titanium nitride layer 64 by a CVD process or a sputtering process. The amorphous silicon layer 65 may be doped with impurities by an ion-implantation process. These steps are performed in the same manner as those in Example 1.

Thereafter, a photoresist (not shown) is applied on the amorphous silicon layer 65, exposed in a lower wiring pattern, and developed to form a resist layer having the lower wiring pattern. By using the resist layer (not shown) as a mask, the amorphous silicon layer 65, the titanium nitride layer 64 and the aluminum layer 63 are selectively and successively etched by a RIE process or a plasma etching process to leave portions of the layers 65, 64 and 63 in the shape of the lower wiring pattern indicated with a hatched region in Fig. 14. Thus, an aluminum lower wiring layer 63 is completed.

Then, an interlaminar insulating layer 66 of SiO₂, PSG or the like is deposited on the whole surface by a CVD process. A photoresist is applied on the whole surface, exposed in a contact hole pattern, and developed to form a resist layer 67 having openings corresponding to contact holes 68a and 68b.

By using the resist layer 67 as a mask, the interlaminar insulating layer 66 is selectively etched by a RIE process or a plasma etching process to open the contact holes 68a and 68b, as shown in Fig. 10. Then, the resist layer 67 is removed with a solvent or by an ashing process.

Next, as shown in Fig. 10, another photoresist is applied on the whole surface, exposed in a pattern covering a normal contact region, and developed to form a resist layer 69. The resist layer 69 covers the contact hole 68a but the contact hole 69b is exposed.

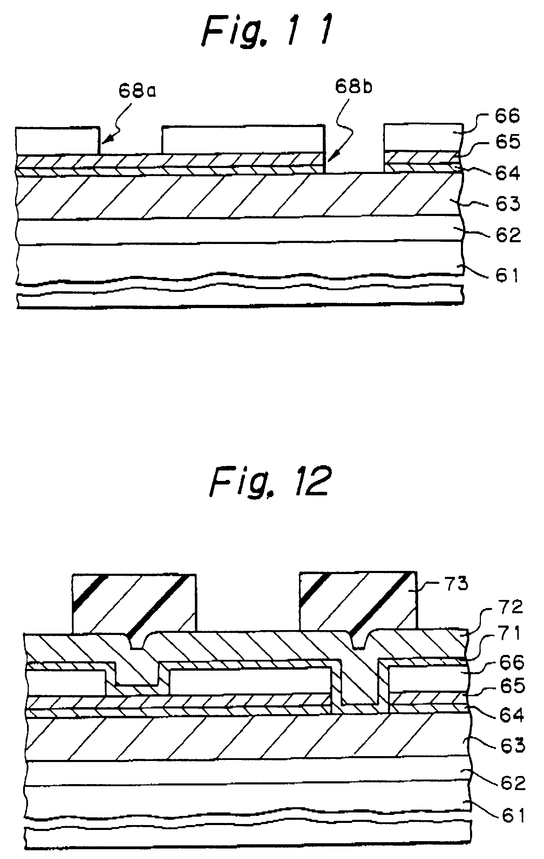

By using the resist layer 69 as a mask, the amorphous silicon layer 65 and the titanium nitride layer 64 are selectively and successively etched by a RIE process or a plasma etching process to complete the contact hole 68b, as shown in Fig. 11. The amorphous silicon layer 65 is exposed in the contact hole 68a, and the aluminum lower wiring layer 63 is exposed in the contact hole 68b. Then, the resist layer 69 is removed with a solvent or by an ashing process.

Next, as shown in Fig. 12, on the whole surface of the interlaminar insulating layer 66 with the contact holes 68a and 68b, a titanium nitride layer 71 for an upper barrier layer is deposited by a sputtering process, and successively an aluminum layer 72 is deposited thereon by a vacuum vapor deposition process or a sputtering process. A photoresist is applied on the whole surface, exposed in an upper wiring pattern, and developed to form a resist layer 73 having the upper wiring pattern.

By using the resist layer 73 as a mask, the aluminum layer 72 and the titanium nitride layer 71 are selectively etched by a RIE process or a plasma etching process to form the upper wiring layers 72a and 72b with the titanium nitride patterned layer 71a and 71b lying thereunder, as shown in Figs. 13 and 14. Then, the resist layer 73 is removed with a solvent or by an ashing process.

The thus produced semiconductor device with an anti-fuse includes an anti-fuse structure F in which the aluminum upper wiring layer 72a with the tungsten layer 71a comes in contact with a contact region 74a of the amorphous layer 65 in the contact hole 68a, and a normal contact structure C in which the upper wiring layer 72a with the titanium nitride layer 71b comes in contact with a contact region 74b of the aluminum lower wiring layer 63 in the contact hole 71b.

Since the amorphous silicon layer 65 is formed between the lower wiring layer and the interlaminar insulating layer and deposited on a flat surface, the layer 65 has a uniform thickness at a predetermined value, as explained in Example 1. Therefore, the writing voltage and ON resistance of the anti-fuses are determined at the predetermined values and are not scattered, so that the circuit characteristics are stable. In an initial state prior to an programming operation, the amorphous silicon layer 65 has a large resistance of about 100 MΩ, whereby the anti-fuse structure F is in a nonconductive state (open state) between the lower wiring layer 63 and the upper wiring layer 72a. Furthermore, since the lower and upper barrier layers 64 and 71a separate the amorphous silicon layer 65 from the lower and upper aluminum layer 63 and 72a, respectively, to prevent diffusion of aluminum into the amorphous silicon layer 65, the resistance of the silicon layer 65 is not varied (decreased).

As explained in Example 1, when a pulse voltage of 8 to 11V (e.g., 10V) is applied across the lower wiring layer 63 and the upper wiring layer 72a in the anti-fuse structure F, Joule heat is locally generated in the amorphous silicon layer 65 to change a portion of the amorphous silicon layer 65 to a polycrystalline state with the result that the resistance of the layer 65 is decreased to about 100Ω. The polycrystalline portion of the layer 65 can pass the current and thus the amorphous silicon layer 65 enters a conductive state. Therefore, among a plurality of the anti-fuse structures formed in an integrated circuit the predetermined ones enter a conductive state so as to form a logic circuit.

### Example 3

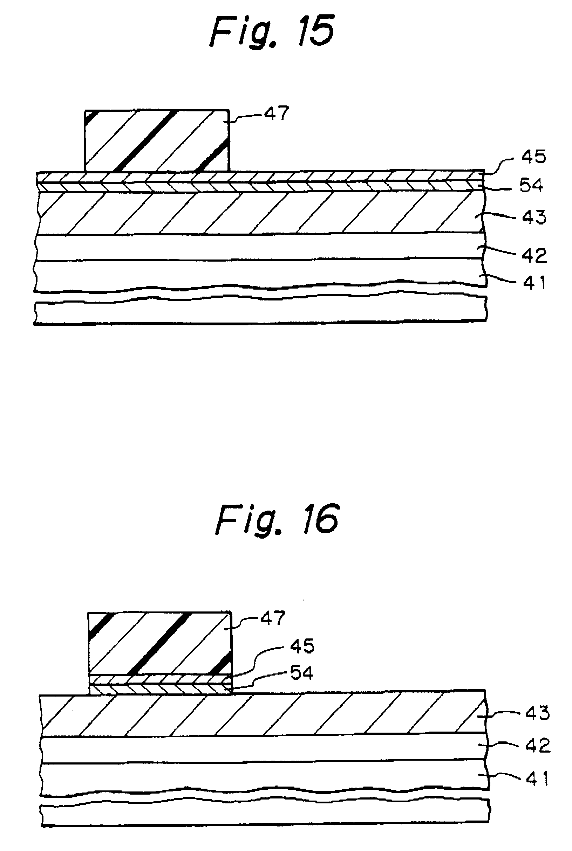

Referring to Figs. 15 to 19, a semiconductor device provided with an anti-fuse according to the third embodiment of the present invention is produced as follows. In this case, posterior to a contact hole is formed in an interlaminar insulating layer, a tungsten layer for an upper barrier that is selectively deposited in the contact hole, while in Example 1 the upper barrier layer (titanium nitride layer) is deposited on the amorphous silicon layer. In Example 3 reference numerals and symbols used in Example 1 denote the same or corresponding parts.

As shown in Fig. 15, the insulating layer (e.g., a SiO₂ layer) 42 is formed on the semiconductor substrate 41 such as a silicon wafer by a thermal oxidizing process or a CVD process. On the whole surface of the insulating layer 42, an aluminum layer 43 is deposited by a vacuum evaporation process or a sputtering process and successively a tungsten (W) layer 54 for a lower barrier layer is deposited by a CVD process or a sputtering process. The CVD process uses a reacting gas of WF₆, and the sputtering process uses an argon gas which colides with a tungsten target to eject tungsten from its surface. Next, the amorphous silicon layer 45 is deposited on the tungsten layer 44 by a CVD process or a sputtering process. The amorphous silicon layer 45 may be doped with impurities by an ion-implantation process. These steps are performed in the same manner as those in Example 1, except for the tungsten deposition step.

Thereafter, photoresist is applied on the amorphous silicon layer 45, exposed and developed so as to leave a resist layer 47 on only an anti-fuse formation region (a hatched region E in Fig. 8) including a contact region.

As shown in Fig. 16, by using the resist layer 47 as a mask, the amorphous silicon layer 45 and the tungsten layer 54 are selectively and successively etched by a RIE process or a plasma etching process. As a result, under the resist layer 47 only, the portions of the layers 45 and 54 in the shape of the anti-fuse formation region E remain. Then, the resist layer 47 is removed with a solvent or by an ashing process.

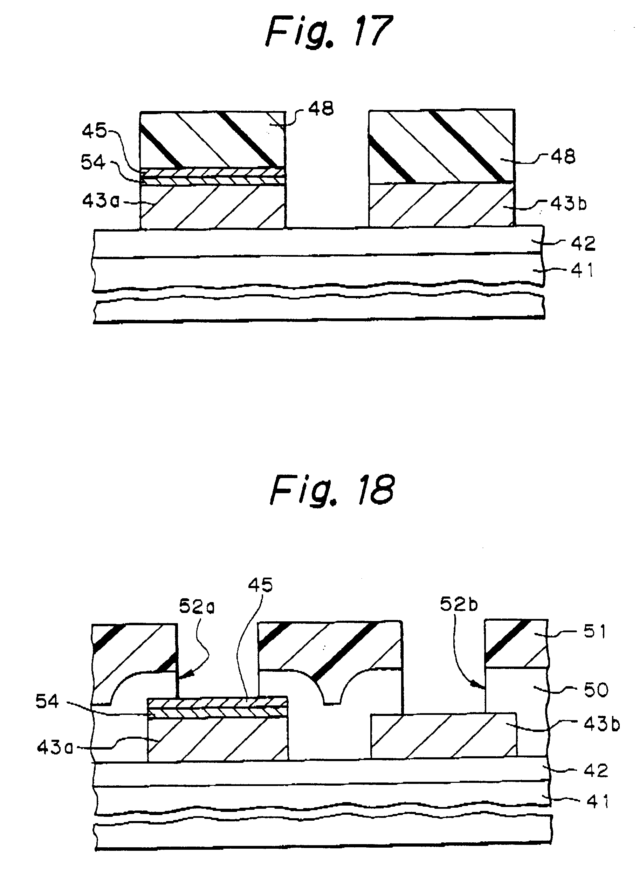

Next, as shown in Fig. 17, another photoresist is applied on the whole surface, exposed in a lower wiring pattern, and developed to form a resist layer 48 having the lower wiring pattern. By using the resist layer 48 as a mask, the aluminum layer 43 is selectively etched by a RIE process or a plasma etching process to form the lower wiring layers 43a and 43b. Then, the resist layer 48 is removed with a solvent or by an ashing process.

As shown in Fig. 18, the interlaminar insulating layer 50 of SiO₂, PSG or the like is deposited on the whole surface by a CVD process. A photoresist is applied on the whole surface, exposed in a contact hole pattern, and developed to form a resist layer 51 having openings corresponding to contact holes 52a and 52b. By using the resist layer 51 as a mask, the interlaminar insulating layer 50 is selectively etched by a RIE process or a plasma etching process to open the contact holes 52a and 52b. The amorphous silicon layer 45 is exposed in the contact hole 52a, and the aluminum lower wiring layer 43b is exposed in the contact hole 52b. Then, the resist layer 51 is removed with a solvent or by an ashing process.

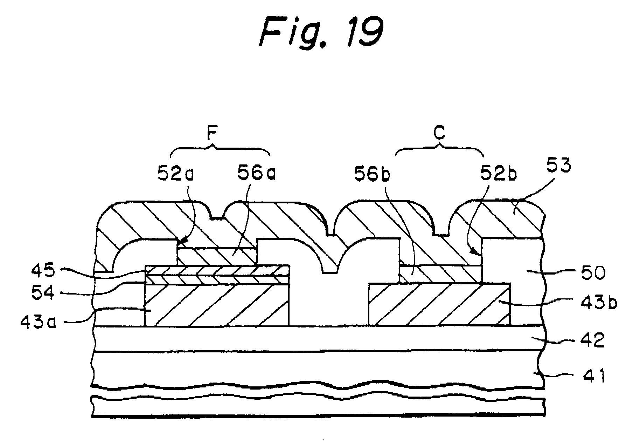

Then, as shown in Fig. 19, by a selective CVD process of tungsten a tungsten layer 56a is formed on the amorphous silicon layer 45 appearing in the contact hole 52a, and simultaneously a tungsten layer 56b is formed on the aluminum wiring layer 43 appearing in the contact hole 56b. For example, such a tungsten growth is performed by using a growth gas of WF₆ at a pressure of 10 to 100 mTorr (1.33 to 13.3 Pa) and at a growing (substrate) temperature of 200 to 350°C. It is possible to carry out the selective CVD growth of refractory metal, such as molybdenum and tantalum instead of tungsten. Next, an aluminum layer 53 is deposited on the whole surface of the interlaminar insulating layer 50 and the tungsten layers 56a and 56b by a vacuum vapor deposition process, a sputtering or the like. A resist layer (not shown) having an upper wiring pattern shape is formed on the aluminum layer 53. By using the resist layer as a mask, the aluminum layer 53 is selectively etched by a RIE process or a plasma etching process to for an upper wiring layer 53. Then, the resist layer 51 is removed with a solvent or by an ashing process.

It is possible to adopt a combination of the titanium nitride layer and the aluminum upper wiring layer shown in Figs. 12 and 13 instead of the above-mentioned combination of the tungsten layer 56a and the aluminum upper wiring layer 53 shown in Fig. 19.

It is also possible to selectively form (deposit) the tungsten layer in the contact hole only by depositing a tungsten layer on the whole surface and then selectively etching a portion of the tungsten layer lying on the interlaminar insulating layer to leave the rest thereof in the contact hole, instead of the selective CVD of tungsten in the contact hole.

The thus produced semiconductor device with an anti-fuse includes an anti-fuse structure F in which (the tungsten layer 56a of) the aluminum upper wiring layer 53 comes in contact with the amorphous layer 45 in the contact hole 52a, and a normal contact structure C in which (the tungsten layer 56b of) the upper wiring layer 53 comes in contact with the aluminum lower wiring layer 43b in the contact hole 52b.

Since the amorphous silicon layer 65 is formed between the lower wiring layer and the interlaminar insulating layer and deposited on a flat surface, the layer 65 has a uniform thickness, as explained in Example 1. Therefore, the writing voltage and ON resistance of the anti-fuses are determined at the predetermined values and are not scattered, so that the circuit characteristics are stable. Since the lower and upper barrier layers 44 and 56a separate the amorphous silicon layer 45 from the lower and upper aluminum layers 43a and 53, respectively, to prevent diffusion of aluminum into the amorphous silicon layer 45, the resistance of the layer 45 is not varied (decreased).

Furthermore, the tungsten layer formed in the contact hole makes the depth of the hole shallow to decrease an aspect ratio of the hole, whereby a step coverage of the upper wiring layer at the edge of the hole is improved.

As explained in Example 1, when a pulse voltage of 8 to 11V (e.g., 10V) is applied across the lower wiring layer 43a and the upper wiring layer 53 in the anti-fuse structure F, Joule heat is locally generated in the amorphous silicon layer 45 to change a portion of the amorphous silicon layer 45 to a polycrystalline state with the result that the resistance of the layer 45 is decreased to about 100Ω. The polycrystalline portion of the layer 45 can pass the current and thus the amorphous silicon layer 45 enters a conductive state. Therefore, among a plurality of the anti-fuse structures formed in an integrated circuit the predetermined ones enter a conductive state so as to form a logic circuit.

### Example 4

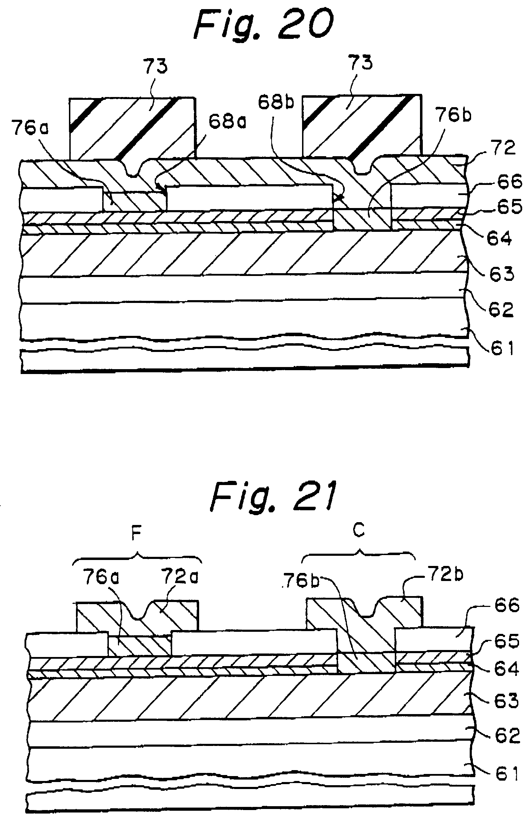

Referring to Figs. 20 and 21, a semiconductor device provided with an anti-fuse according to the fourth embodiment of the present invention is produced as follows. In this case, posterior to the complete area of the contact holes as shown in Fig. 11 (in Example 2), a tungsten layer for an upper barrier is selectively deposited in the contact hole only, instead of the deposition (formation) of the upper barrier layer (titanium nitride layer) on the whole surface in Example 2. In Example 4 reference numerals and symbols used in Example 2 denote the same or corresponding parts.

After the semiconductor device shown in Fig. 11 is fabricated, as shown in Fig. 20, by a selective CVD process of tungsten a tungsten layer 76a is formed on the amorphous silicon layer 65 appearing in the contact hole 68a, and simultaneously a tungsten layer 76b is formed on the aluminum wiring layer 63 appearing in the contact hole 68b. For example, such a tungsten growth is performed by using a growth gas of WF₆ at a pressure of 10 to 100 mTorr (1.33 to 13.3 Pa) and) at a growing (substrate) temperature of 200 to 350°C. Next, an aluminum layer 73 is deposited on the whole surface of the interlaminar insulating layer 66 and the tungsten layers 76a and 76b by a vacuum vapor deposition process, a sputtering or the like. A resist layer 73 having an upper wiring pattern shape is formed on the aluminum layer 72.

As shown in Fig. 21, by using the resist layer 73 as a mask, the aluminum layer 72 is selectively etched by a RIE process or a plasma etching process to for the upper wiring layers 72a and 72b. Then, the resist layer 73 is removed with a solvent or by an ashing process.

The thus produced semiconductor device with an anti-fuse includes an anti-fuse structure F in which the aluminum upper wiring layer 53 is connected to the amorphous layer 45 through the tungsten layer 56a in the contact hole 68a, and a normal contact structure C in which the upper wiring layer 53 is connected to the aluminum lower wiring layer 63 through the tungsten layer 56b in the contact hole 68b.

As mentioned above, the amorphous silicon layer 65 has a uniform thickness, and the lower and upper barrier layers 64 and 76a prevent diffusion of aluminum into the amorphous silicon layer 65. Furthermore, the tungsten layer formed in the contact hole makes the depth of the hole shallow to decrease an aspect ratio of the hole, whereby a step coverage of the upper wiring layer at the edge of the hole is improved.

As explained in Example 1, when a pulse voltage of 8 to 11V (e.g., 10V) is applied across the lower wiring layer 43a and the upper wiring layer 53 in the anti-fuse structure F, Joule heat is locally generated in the amorphous silicon layer 65 to change a portion of the amorphous silicon layer 65 to a polycrystalline state with the result that the resistance of the layer 65 is decreased to about 100Ω. Thus, the amorphous silicon layer 65 enters a conductive state.

### Example 5

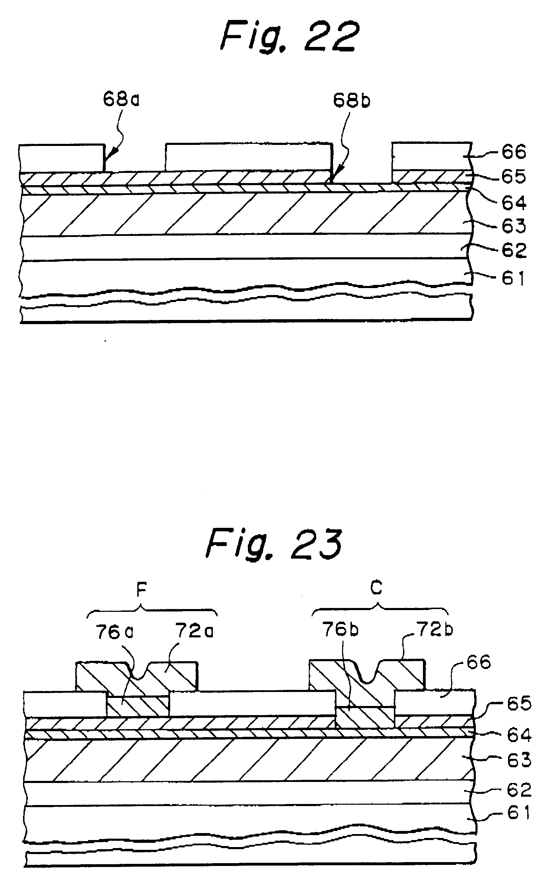

Referring to Figs. 22 and 23, a semiconductor device provided with an anti-fuse according to the fifth embodiment of the present invention is produced as follows. In this case, where the contact hole 68b shown in Fig. 11 is completed from the device state shown in Fig. 10 in Example 2, the amorphous silicon layer 65 is selectively etched without etching the titanium nitride layer 64, as shown in Fig. 22. Then, the selective deposition of tungsten in the contact hole in Example 4 is adopted instead of the deposition of titanium nitride on the whole surface in Example 2. In Example 5 reference numerals and symbols used in Examples 2 and 4 denote the same or corresponding parts.

After the completion of the contact holes 68a and 68b (Fig. 22), as shown in Fig. 23, by a selective CVD process of tungsten a tungsten layer 76a is formed on the amorphous silicon layer 65 appearing in the contact hole 68a, and simultaneously a tungsten layer 76b is formed on the titanium nitride layer 64 appearing in the contact hole 68b. Next, an aluminum layer is deposited on the whole surface of the interlaminar insulating layer 66 and the tungsten layers 76a and 76b by a vacuum vapor deposition process, a sputtering or the like, and a resist layer (not shown) having an upper wiring pattern shape is formed on the aluminum layer (cf. Fig. 20).

By using the resist layer as a mask, the aluminum layer 72 is selectively etched by a RIE process or a plasma etching process to for the upper wiring layers 72a and 72b. Then, the resist layer is removed with a solvent or by an ashing process.

The thus produced semiconductor device with an anti-fuse includes an anti-fuse structure F in which the aluminum upper wiring layer 72a is connected to the amorphous layer 65 through the tungsten layer 76a in the contact hole 68a, and a normal contact structure C in which the upper wiring layer 72b is connected to the aluminum lower wiring layer 63 through the tungsten layer 76b in the contact hole 68b and the titanium nitride layer 64.

As mentioned above, the amorphous silicon layer 65 has a uniform thickness, and the lower and upper barrier layers 64 and 76a prevent diffusion of aluminum into the amorphous silicon layer 65. Furthermore, the tungsten layer formed in the contact hole makes the depth of the hole shallow to decrease an aspect ratio of the hole, whereby a step coverage of the upper wiring layer at the hole is improved.

As explained in Example 1, when a pulse voltage of 8 to 11V (e.g., 10V) is applied across the lower wiring layer 63 and the upper wiring layer 72a in the anti-fuse structure F, Joule heat is locally generated in the amorphous silicon layer 65 to change a portion of the amorphous silicon layer 65 to a polycrystalline state with the result that the resistance of the layer 65 is decreased to about 100Ω. Thus, the amorphous silicon layer 65 enters a conductive state.

As mentioned above, at the deposition of the upper barrier layer, since there is no edge of the amorphous silicon layer in the contact hole, the step coverage problem of the barrier layer on the amorphous silicon layer does not occur, and it is unnecessary to thicken the barrier layer.

It will be obvious that the present invention is not restricted to the above-mentioned embodiments and that many variations are possible for persons skilled in the art without departing from the scope of the invention. For example, it is possible to adopt amorphous semiconductor material, such as germanium and carbon, instead of the amorphous silicon used in Examples 1 to 5. it is also possible to make the barrier layer of refractory metal (high-melting point metal), such as molybdenum, tantalum and titanium-tungsten, or refractory metal nitride, such as tungsten nitride and tantalum nitride, instead of the tungsten and titanium nitride used in Examples 1 to 5. Furthermore, it is possible to make the wiring layer of polycrystalline silicon, metal silicide, polycide or refractory metal (W, Mo, Ta, TiW, etc.), instead of aluminum. Where the wiring layer is made of the conductive material other than aluminum, there is no necessity for forming the barrier layer.

## Claims

1. A semiconductor device provided with an anti-fuse comprising:
a semiconductor substrate (41, 61);
an insulating layer (42, 62) formed on said semiconductor substrate;
a lower wiring layer (43a, 63) formed above said insulating layer;
an amorphous semiconductor layer (45, 65) formed above said lower wiring layer;
an interlaminar insulating layer (50, 66) which is formed on said insulating layer and said amorphous semiconductor layer and has contact holes (52a, 52b) reaching said amorphous semiconductor layer; and,
an upper wiring layer (53, 72a) which is formed on said interlaminar insulating layer and is connected to said amorphous semiconductor layer through said contact hole.

2. A semiconductor device according to claim 1, further comprising a lower barrier layer (44, 64) formed between said lower wiring layer (43a, 63) and said amorphous semiconductor layer.

3. A semiconductor device according to claim 1 or 2, further comprising an upper barrier layer (44, 56a, 71a, 76a) formed between said amorphous semiconductor layer (45, 65) and said upper wiring layer.

4. A semiconductor device according to claim 2 or 3, said barrier layer (44, 64, 46, 56a, 71a, 76a) is made from tungsten, molybdenum, tantalum,titanium-tungsten, titanium nitride, tungsten nitride or tantalum nitride.

5. A semiconductor device according to claim 3 or 4, further comprising said upper barrier layer (56a, 76a) formed in said contact hole.

6. A semiconductor device according to claim 3, 4 or 5, further comprising said upper barrier layer (71a) formed under said upper wiring layer and extending on said interlaminar insulating layer.

7. A semiconductor device according to any one of the preceding claims, wherein said amorphous semiconductor layer (45, 65) is made of amorphous silicon.

8. A semiconductor device according to any one of the preceding claims, wherein said wiring layer or layers 43a, 63; 53, 72a) is made from aluminium, polycrystalline silicon, metal silicide, polycide or refractory metal.

9. A method of producing a semiconductor device with an anti-fuse comprising the steps of:
(a) forming an insulating layer (42, 62) on a semiconductor substrate (41, 61);
(b) forming a lower wiring layer (43a, 63) above said insulating layer;
(c) forming an amorphous semiconductor layer (45, 65) for an anti-fuse above said lower wiring layer;
(d) forming an interlaminar insulating layer (50, 66) having a contact hole (52a, 52b) reaching said amorphous semiconductor layer, on said insulating layer and said amorphous semiconductor layer; and,
(e) forming an upper wiring layer (53, 72a) connecting to said amorphous semiconductor layer through said contact hole, on said interlaminar insulating layer.

10. A method according to claim 9, further comprising a step of forming a lower barrier layer (44, 64) on said lower wiring layer, between the steps (b) and (c).

11. A method according to claim 10 or 11 further comprising a step of forming an upper barrier layer (46; 56a, 71a, 76a) on said amorphous semiconductor layer, between the steps (c) and (d) or between the steps (d) and (e).

12. A method according to claim 11, wherein said upper wiring layer is formed by patterning a conductive layer therefore and successively said upper barrier layer (71a) is patterned into the same pattern as that of the upper wiring layer.

13. A method according to claim 11 or 12, wherein said upper barrier layer (56a, 76a) is formed in said contact hole only and on said amorphous semiconductor layer.
